# EUROPÄISCHE PATENTSCHRIFT

(11) **EP 0 910 822 B1**
(45) Veröffentlichungstag und Bekanntmachung des Hinweises auf die Patenterteilung: **19.01.2000**
(21) Anmeldenummer: 97932726.9
(22) Anmeldetag: 02.07.1997
(51) Int. Cl.: G06F 1/18, H05K 7/14

(54) **GEHÄUSE FÜR EIN ELEKTRONISCHES GERÄT UND ELEKTRONISCHES GERÄT MIT EINEM SOLCHEN GEHÄUSE**
HOUSING FOR ELECTRONIC EQUIPMENT AND ELECTRONIC EQUIPMENT PROVIDED WITH THIS HOUSING
BOITIER POUR UN APPAREIL ELECTRONIQUE ET APPAREIL ELECTRONIQUE POURVU D'UN TEL BOITIER

(30) Priorität: 09.07.1996 DE 19627651
(43) Veröffentlichungstag der Anmeldung: 28.04.1999
(73) Patentinhaber: Siemens Nixdorf Informationssysteme AG, 33106 Paderborn (DE)
(72) Erfinder: BAITZ, Guenter, D-13503 Berlin (DE)
(74) Vertreter: Epping, Wilhelm, Dr.-Ing.
(86) Internationale Anmeldenummer: DE9701394
(87) Internationale Veröffentlichungsnummer: WO9801801

(56) Entgegenhaltungen:
- EP-A- 0 687 983
- WO-A-95/14367
- US-A- 5 407 362
- "ENHANCED RISER CARD WITH EXPANSION FUNCTION CAPABILITY FOR PERSONAL COMPUTERS" IBM TECHNICAL DISCLOSURE BULLETIN, Bd. 37, Nr. 7, 1.Juli 1994, Seiten 189-191, XP000455481

## Beschreibung

Die Erfindung betrifft ein Gehäuse für ein PC-basiertes elektronisches Gerät nach dem Oberbegriff des Anspruchs 1 und ein elektronisches Gerät mit einem solchen Gehäuse.

Ein Gehäuse der genannten Art für ein PC-basiertes Steuergerät ist aus der WO 95/14367 A1 bekannt. Darin ist parallel zu der Bodenplatte des Gehäuses eine Basis-Leiterplatte angeordnet, auf die eine senkrecht dazu ausgerichtete AT-Bus-Adapterkarte aufgesteckt ist. Diese ist mit zwei Steckverbindern bestückt, in welche jeweils eine Zusatz-Leiterplatte einsteckbar ist. Letztere sind parallel zu der Basis-Leiterplatte ausgerichtet.

Die Zahl der Zusatz-Leiterplatten ist aus mechanischer Sicht nur durch die Zahl der Steckverbinder auf der AT-Bus-Adapterkarte begrenzt, sie bestimmt aber die Höhe der AT-Bus-Adapterkarte und damit die Gehäusehöhe. Es muß also in jedem Fall ein Gehäuse bereitgestellt werden, das Raum für die maximal erforderliche Zahl von Zusatz-Leiterplatten bietet. In vielen Anwendungsfällen kommt also ein unnötig großes und damit teures Gehäuse zum Einsatz.

Aufgabe der Erfindung ist es daher, ein Gehäuse für ein PC-basiertes elektronisches Gerät anzugeben, welches für eine Minimalbestückung mit Zusatz-Leiterplatten ausgelegt ist, jedoch eine einfache Erweiterungsmöglichkeit hinsichtlich der Zahl der Zusatz-Leiterplatten bietet.

Die Aufgabe wird durch das Kennzeichen des Anspruchs 1 gelöst.

In das Gehäuse ist eine parallel zu einer ersten Gehäusewand auszurichtende Basis-Leiterplatte einsetzbar, auf der ein PC-Bus-Steckverbinder für eine normal zu der Leiterplatte aufsteckbare Adapterkarte angeordnet ist. In die der ersten Gehäusewand gegenüberliegende Gehäusewand ist ein Durchbruch eingebracht, durch welchen bei eingesetzter Basis-Leiterplatte eine in den PC-Bus-Steckverbinder eingesteckte Adapterkarte wenigstens mit einem Teil ihrer Fläche hindurchzuragen vermag. Der Durchbruch kann als Schlitz in der Gehäusewand, aber auch durch Fortlassen dieser Gehäusewand gebildet sein.

Bei Verwendung einer Adapterkarte, die für eine Minimalbestückung des Gehäuses mit Zusatz-Leiterplatten ausgelegt ist, die also nicht aus dem Gehäuse herausragt, ist der Durchbruch durch eine Abdeckplatte verschließbar. Gleiches gilt bei Verzicht auf eine Adapterkarte. Die Abdeckplatte ist vorzugsweise lösbar, beispielsweise durch Schrauben oder eine Rastverbindung, mit dem Gehäuse verbunden. Dies erlaubt eine spätere Aufrüstung der Anordnung mit weiteren Zusatz-Leiterplatten.

In weiterer Ausgestaltung der Erfindung ist an die mit dem Durchbruch versehene Gehäusewand ein Zusatzgehäuse ansetzbar, dessen dann dem Gehäuse benachbarte Gehäusefläche mit einer den Durchbruch freilassenden Gehäuseöffnung versehen ist. Die Gehäuseöffnung ist aus einer dem Gehäuse zugewandten Wand des Zusatzgehäuses ausgeschnitten und entspricht in ihren Abmessungen dem Durchbruch in der Wand des Gehäuses. Sie kann aber auch durch Fortlassen einer Gehäusewand des Zusatzgehäuses gebildet sein, so daß das Zusatzgehäuse als Abdeckhaube für einen zwischen ihr und dem Gehäuse eingeschlossenen Raum ausgebildet ist. Das Zusatzgehäuse ist an dem Gehäuse lösbar zu befestigen, wozu wiederum eine Schraub- oder Rastverbindung benutzt werden kann.

Weitere Ausprägungen und Vorteile der Erfindung sowie deren Verwendung bei einem elektronischen Gerät sind nachfolgend anhand eines in der Zeichnung dargestellten Ausführungsbeispiels beschrieben. Es zeigt
- Fig. 1: eine perspektivische Ansicht eines elektronischen Gerätes mit einer Gehäuse-Zusatzgehäuse-Kombination in Explosionsdarstellung,
- Fig. 2: eine schematische Seitenansicht des elektronischen Gerätes in einer Maximalkonfiguration,
- Fig. 3: eine schematische Seitenansicht des elektronischen Gerätes in einer Minimalkonfiguration,
- Fig. 4: einen vergrößerten Ausschnitt einer mit einem Durchbruch versehenen Gehäusewand in geschnittener Seitenansicht.

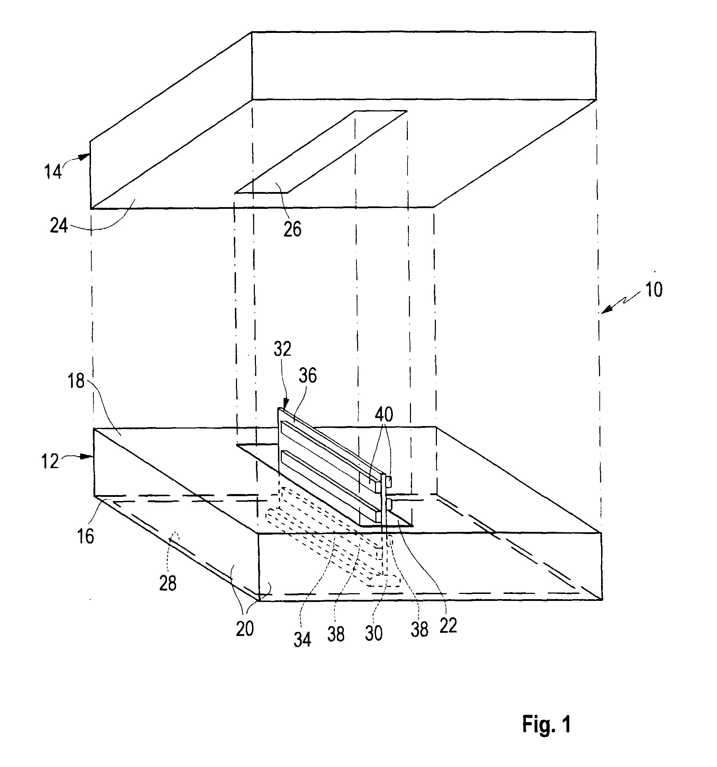

In Fig. 1 ist ein PC-basiertes elektronisches Gerät 10 mit einer aus einem quaderförmigen Gehäuse 12 und einem Zusatzgehäuse 14 bestehenden Umkleidung in Explosionsdarstellung wiedergegeben. Das Gehäuse hat sechs Gehäusewände: einen Boden 16, eine Deckplatte 18 sowie Seitenwände 20, von denen in Fig. 1 nur zwei zu sehen sind. Aus der Deckplatte 18 ist ein Durchbruch 22 ausgeschnitten.

Das Zusatzgehäuse 14 ist ebenfalls quaderförmig und hat eine der Deckplatte 18 entsprechende Grundfläche. In die Bodenplatte 24 des Zusatzgehäuses 14 ist eine Gehäuseöffnung 26 eingebracht, die -wie an den strichpunktierten Fluchtlinien zu sehen ist- mit dem Durchbruch 22 fluchtet. Der Durchbruch und die Gehäuseöffnung können auch unterschiedlich geformt sein, auch kann die Bodenplatte 24 völlig fehlen. Wesentlich ist lediglich, daß bei auf das Gehäuse 12 aufgesetztem Zusatzgehäuse 14 die resultierende lichte Weite eines durch die Ränder des Durchbruchs 22 oder der Gehäuseöffnung 26 begrenzten Durchlasses das Hindurchtreten einer weiter unten beschriebenen Adapterkarte 32 gestattet.

Eine Basis-Leiterplatte 28 ist parallel zum Boden 16 in das Gehäuse 12 eingebaut. Diese ist mit einem PC-Bus-Steckverbinder 30 bestückt, der so auf der Basis-Leiterplatte 28 angeordnet ist, daß eine in ihn eingesteckte Adapterkarte 32 durch den Durchbruch 26 hindurchzuragen vermag. Eine erste Teilfläche 34 der Adapterkarte 32 liegt innerhalb des Gehäuses 12, während eine zweite Teilfläche 36 der Adapterkarte 32 aus dem Durchbruch 22 heraus und bei auf das Gehäuse 12 aufgesetztem Zusatzgehäuse 14 in letzteres hinein ragt. Die Teilflächen 34, 36 der Adapterkarte 32 sind beidseitig mit zweiten Steckverbindern 38 bzw. dritten Steckverbindern 40 bestückt.

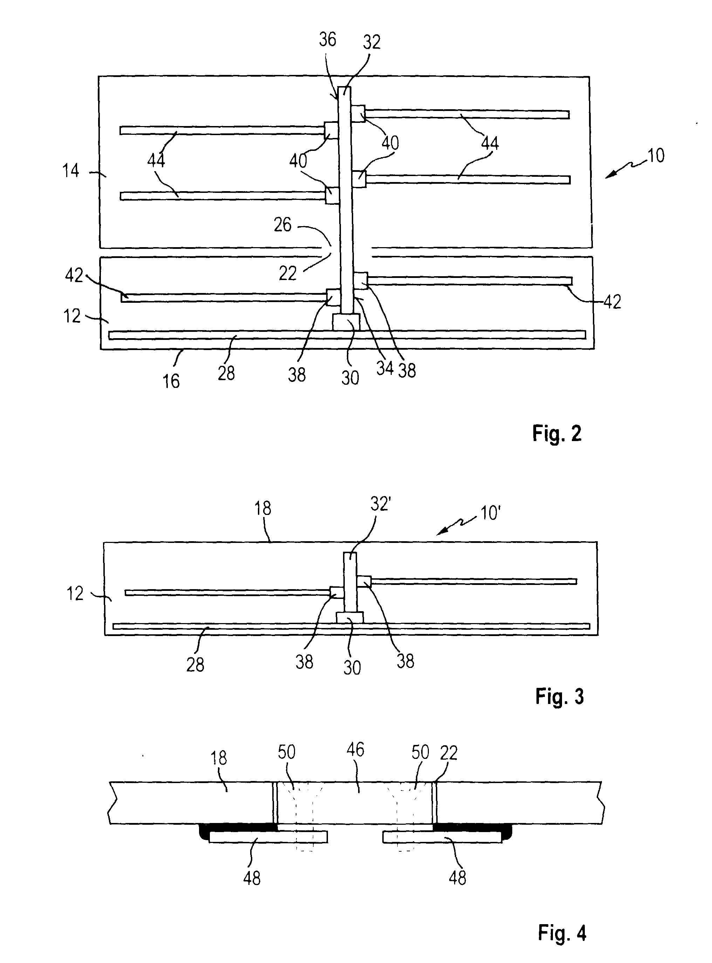

In Fig. 2 ist die vorbeschriebene Anordnung mit einer maximalen Bestückung mit Zusatz-Leiterplatten 42, 44 schematisch in einer geschnittenen Seitenansicht dargestellt. In die im Gehäuse 12 befindlichen zweiten Steckverbinder 38 sind Zusatz-Leiterplatten 42 und in die von dem Zusatzgehäuse 14 umfangenen dritten Steckverbinder 40 Zusatz-Leiterplatten 44 so eingesteckt, daß sie parallel zu der Basis-Leiterplatte 28 ausgerichtet sind.

In Fig. 3 ist ein elektronisches Gerät 10' mit Zusatz-Leiterplatten 42 schematisch in einer geschnittenen Seitenansicht dargestellt. Es ist eine Adapterkarte 32' in den PC-Bus-Steckverbinder 30 eingesteckt, deren Höhe den oberhalb der Basis-Leiterplatte 28 im Gehäuse 12 zur Verfügung stehenden Raum nicht überschreitet. In die auf der Adapterkarte 32' befindlichen zweiten Steckverbinder 38 sind zwei Zusatz-Leiterplatten 42 eingesteckt.

Fig. 4 zeigt in einem vergrößerten Ausschnitt den oberhalb der Adapterkarte 32' befindlichen Bereich der Deckplatte 18 in Fig. 3. Der Durchbruch 22 ist durch eine Abdeckplatte 46 niveaugleich mit der Deckplatte 18 verschlossen. Die Abdeckplatte 46 liegt auf Auflagen 48 auf, welche im Inneren des Gehäuses 12 mit der Deckplatte 18 beispielsweise durch Schweißen oder Kleben verbunden sind. Die Abdeckplatte 46 ist mit Schrauben 50 lösbar auf den Auflagen 48 befestigt.

Bei dem elektronischen Gerät 10 mag es sich beispielsweise um die Elektronikbox einer PC-basierten Registrierkasse oder eines Bürocomputers handeln. Die Rechnereinheit ist dabei auf einer Basis-Leiterplatte 28 untergebracht. Häufig genügt bei einem solchen Gerät die Bestückung mit einer oder zwei Zusatz-Leiterplatten, die z.B. kassenoder netzwerksspezifische Zusatz-Schaltkreise tragen können. In diesem Fall genügt eine Ausstattung gemäß Fig. 3. Soll aber ein solches Gerät weitere Funktionen übernehmen, so läßt sich in einfacher Weise die Abdeckplatte 46 entfernen und die kurze Adapterkarte 32' durch eine höhere Adapterkarte 32, welche neben den zweiten Steckverbindern 38 mit dritten Steckverbindern 40 bestückt ist, ersetzen. Das Zusatzgehäuse 14 wird auf das Gehäuse 12 aufgesetzt. Die Zusatz-Leiterplatten 42 können wie zuvor in dem Gehäuse 12 angeordnet sein, während weitere Zusatz-Leiterplatten 44 in die dritten Steckverbinder 40 der in das Zusatzgehäuse 14 ragenden zweiten Teilfläche 36 der Adapterkarte 32 einsteckbar sind.

Da alle für das Funktionieren eines PC benötigten Baugruppen in dem Gehäuse 12 unterzubringen sind, hat das Zusatzgehäuse 14 lediglich die Funktion einer Abdeckung. Es kann deshalb sehr einfach aufgebaut sein. Andererseits ist es aber auch möglich, in dem Zusatzgehäuse 14 Peripheriegeräte, wie z.B. zusätzliche Magnetplattenlaufwerke, ein Fensterscanner für Strichcodeerfassung oder eine Notstromversorgung unterzubringen.

## Patentansprüche

1. Gehäuse (12) für ein PC-basiertes elektronisches Gerät (10), in welches eine Basis-Leiterplatte (28) einsetzbar ist, wobei auf der Basis-Leiterplatte (28) ein PC-Bus-Steckverbinder (30) für eine senkrecht zu der Basis-Leiterplatte (28) aufsteckbare weitere Leiterplatte (32) angeordnet ist, die ihrerseits mit mindestens einem weiteren Steckverbinder (38; 40) bestückt ist, in welchen eine Zusatzleiterplatte (42; 44) einsteckbar ist,
**dadurch gekennzeichnet,**
daß in eine Gehäusewand (18) ein Durchbruch (22) eingebracht ist, durch welchen hindurch bei eingesetzter Basis-Leiterplatte (28) die in den PC-Bus-Steckverbinder (30) eingesteckte weitere Leiterplatte (32) wenigstens mit einem zumindest einen weiteren Steckverbinder (40) tragenden Teil (36) ihrer Fläche hindurchzuragen vermag.

2. Gehäuse nach Anspruch 1, bei dem die Basis-Leiterplatte (28) parallel zu einer ersten Gehäusewand (16) anbringbar ist und der Durchbruch (22) über dem PC-Bus-Steckverbinder (30) in eine der ersten Gehäusewand (16) gegenüberliegende zweite Gehäusewand (18) eingebracht ist.

3. Gehäuse nach Anspruch 1 oder 2, bei dem der Durchbruch (22) durch eine Abdeckplatte (46) verschließbar ist.

4. Gehäuse nach Anspruch 3, bei dem die Abdeckplatte (46) lösbar mit dem Gehäuse (12) verbunden ist.

5. Gehäuse nach Anspruch 1 oder 2, bei dem an die mit dem Durchbruch (22) versehene Gehäusewand (18) ein Zusatzgehäuse (14) ansetzbar ist, dessen dann dem Gehäuse (12) benachbarte Gehäusefläche (24) mit einer den Durchbruch (22) freilassenden Gehäuseöffnung (26) versehen ist.

6. Gehäuseanordnung nach Anspruch 5, bei der das Zusatzgehäuse (14) an dem Gehäuse (12) lösbar zu befestigen ist.

7. PC-basiertes elektronisches Gerät (10) mit einem Gehäuse (12) oder einer Gehäuseanordnung (12, 14) nach einem der vorhergehenden Ansprüche.

8. Elektronisches Gerät nach Anspruch 7 mit einer durch den Durchbruch (22) hindurchragenden Adapterkarte (32), welche auf einem von dem Gehäuse (12) umschlossenen ersten Teil (34) ihrer Fläche wenigstens einen zweiten Steckverbinder (38) für eine Zusatz-Leiterplatte (42) und auf dem aus dem Gehäuse (12) ragenden Teil (36) ihrer Fläche wenigstens einen dritten Steckverbinder (40) für eine Zusatz-Leiterplatte (44) trägt.

9. Elektronisches Gerät nach Anspruch 8 mit einer Gehäuseanordnung (12, 14) entsprechend Anspruch 5 oder 6, bei dem der aus dem Gehäuse (12) herausragende Teil (36) der Adapterkarte (32) von dem Zusatzgehäuse (14) umfangen ist.

10. Elektronisches Gerät nach einem der Ansprüche 7 bis 9, bei dem die Adapterkarte (32, 32') beidseitig mit zweiten Steckverbindern (38) oder auch dritten Steckverbindern (40) für Zusatz-Leiterplatten (42, 44) versehen ist.

## Claims

1. Housing (12) for PC-based electronic equipment (10), into which a base printed circuit board (28) can be inserted, a PC bus plug connector (30) for a further printed circuit board (32) which can be fitted on vertically to the base printed circuit board (28) being disposed on the base printed circuit board (28), which further printed circuit board, is, for its part, equipped with at least one further plug connector (38; 40), into which a supplementary printed circuit board (42; 44) can be inserted,
**characterized in that**
an aperture (22) is formed in a housing wall (18), through which aperture, when the base printed circuit board (28) has been inserted, the further printed circuit board (32) inserted into the PC bus plug connector (30) is able to protrude at least by a part (36) of its surface, which part carries at least one further plug connector (40).

2. Housing according to Claim 1, in which the base printed circuit board (28) can be fitted parallel to a first housing wall (16) and the aperture (22) is formed over the PC bus plug connector (30) in a second housing wall (18) opposite the first housing wall (16).

3. Housing according to Claim 1 or 2, in which the aperture (22) can be closed off by a cover plate (46).

4. Housing according to Claim 3, in which the cover plate (46) is releasably connected to the housing (12).

5. Housing according to Claim 1 or 2, in which a supplementary housing (14) can be fitted onto the housing wall (18) provided with the aperture (22), that housing surface (24) of which supplementary housing which is then adjacent to the housing (12) being provided with a housing opening (26) which leaves the aperture (22) free.

6. Housing arrangement according to Claim 5, in which the supplementary housing (14) is to be releasably secured to the housing (12).

7. PC-based electronic equipment (10) having a housing (12) or a housing arrangement (12, 14) according to one of the preceding claims.

8. Electronic equipment according to Claim 7 having an adaptor card (32) which protrudes through the aperture (22) and which carries, on a first part (34) of its surface, which first part is surrounded by the housing (12), at least one second plug connector (38) for a supplementary printed circuit board (42) and, on that part (36) of its surface which protrudes from the housing (12), at least one third plug connector (40) for a supplementary printed circuit board (44).

9. Electronic equipment according to claim 8 having a housing arrangement (12, 14) according to Claim 5 or 6, in which that part (36) of the adaptor card (32) which protrudes from the housing (12) is embraced by the supplementary housing (14).

10. Electronic equipment according to one of claims 7 to 9, in which the adaptor card (32, 32') is provided on both sides with second plug connectors (38) or even third plug connectors (40) for supplementary printed circuit boards (42, 44).

## Revendications

1. Boîtier (12) pour un appareil (10) électronique à base d'un ordinateur personnel, dans lequel une plaquette (28) à circuit imprimé de base peut être insérée, un connecteur (30) d'enfichage de bus de PC pour une autre plaquette (32) à circuit imprimé pouvant être enfichée perpendiculairement à la plaquette (28) à circuit imprimé de base étant monté sur la plaquette (28) à circuit imprimé de base, cette autre plaquette étant munie pour sa part d'au moins un autre connecteur (38, 40) à enfichage dans lequel peut être enfichée une plaquette (42, 44) à circuit imprimé supplémentaire,
caractérisé en ce qu'il est ménagé dans une paroi (18) du boîtier une traversée (22) par laquelle, lorsque la plaquette (28) à circuit imprimé de base est insérée, l'autre plaquette (32) à circuit imprimé, enfichée dans le connecteur (30) à enfichage du bus de PC, peut passer par au moins une partie (36) de sa surface portant un autre connecteur (40) d'enfichage.

2. Boîtier selon la revendication 1, dans lequel la plaquette (28) à circuit imprimé de base peut être disposée parallèlement à une première paroi (16) du boîtier et la traversée (22) peut être ménagée au dessus du connecteur (30) d'enfichage du bus de PC dans une deuxième paroi (18) de boîtier opposée à la première paroi (16) de boîtier.

3. Boîtier selon la revendication 1 ou 2, dans lequel la traversée (22) peut être fermée par une plaque (46) de recouvrement.

4. Boîtier selon la revendication 3, dans lequel la plaque (46) de recouvrement est reliée de manière amovible au boîtier (12).

5. Boîtier selon la revendication 1 ou 2, dans lequel il est possible de mettre sur la paroi (18) de boîtier munie de la traversée (22) un boîtier (14) supplémentaire dont la surface (24) voisine du boîtier (12) est munie d'une ouverture (26) dégageant la traversée (22).

6. Dispositif à boîtier suivant la revendication 5, dans lequel le boîtier (14) supplémentaire peut être fixé de manière amovible au boîtier (12).

7. Appareil (10) électronique à base d'un PC ayant un boîtier (12) ou un dispositif (12, 14) de boîtier suivant l'une des revendications précédentes.

8. Appareil électronique suivant la revendication 7, comprenant une carte (22) d'adapteur faisant saillie par la traversée (32) et portant sur une première partie (34) de sa surface entourée par le boîtier (12) au moins un deuxième connecteur (38) d'enfichage pour une plaquette (42) à circuit imprimé supplémentaire et sur la partie (36) de sa surface faisant saillie du boîtier (12) au moins un troisième connecteur (40) à enfichage pour une plaquette (44) à circuit imprimé supplémentaire.

9. Appareil électronique suivant la revendication 8, comprenant un dispositif (12, 14) à boîtier suivant la revendication 5 ou 6, dans lequel la partie (36) de la carte (32) d'adapteur faisant saillie du boîtier (12) est entourée du boîtier (14) supplémentaire.

10. Appareil électronique suivant l'une des revendications 7 à 9, dans lequel la carte (32, 32') d'adapteur est munie de part et d'autre de deux connecteurs (38) d'enfichage ou également de troisième connecteur (40) d'enfichage pour des plaquettes (42, 44) à circuit imprimé supplémentaires.
